# EUROPEAN PATENT APPLICATION

(11) **EP 2 442 369 A2**
(43) Date of publication of application: **18.04.2012**
(21) Application number: 10828481.1
(22) Date of filing: 01.11.2010
(51) Int. Cl.: H01L 31/042

(54) **SOLAR CELL AND METHOD FOR MANUFACTURING SAME**

(30) Priority: 03.11.2009 KR 20090105424
(71) Applicant: LG Innotek Co., Ltd., Seoul 100-714 (KR)
(72) Inventor: LEE, Dong Keun, Seoul 100-714 (KR)
(74) Representative: Novagraaf Technologies
(86) International application number: PCT/KR2010/007616
(87) International publication number: WO 2011/055946

(57) **Abstract**

There is provided a solar cell according to an exemplary embodiment including: a plurality of cells of the solar cell formed on a substrate and each having a rear electrode pattern, a light absorbing layer, a buffer layer, and a front electrode; a through-hole penetrating the substrate; and a bus bar electrically connected with the rear electrode pattern through the through-hole.

There is provided a manufacturing method of a solar cell according to another exemplary embodiment, including: forming a through-hole penetrating a substrate; forming a bus bar in an area corresponding to the through-hole on a rear surface of the substrate; and forming a plurality of cells of the solar cell each having a rear electrode pattern, a light absorbing layer, a buffer layer, and a front electrode, on a front surface of the substrate, wherein the bus bar is electrically connected with the rear electrode pattern through the through-hole.

## Description

### TECHNICAL FIELD

Exemplary embodiments relate to a solar cell and a manufacturing method thereof.

### BACKGROUND

In recent years, with the increase in demands for energy, solar cells converting solar energy into electric energy have been developed.

In particular, a CIGS-based solar cell which is a pn hetero junction device having a substrate structure including a glass substrate, an electrode layer on a rear surface of metal, a p-type CIGS-based light absorbing layer, a high resistance buffer layer, and an n-type window layer has been widely used.

However, a bus bar is formed on an n-type window layer at the time of forming the CIGS based solar cell and the bus bar has a large width, and as a result, an effective area for forming cells of the solar cell is narrowed.

Further, in order to connect a signal of the bus bar to a junction box of a rear surface of a substrate, additional processes for extending the signal of the bus bar to the rear surface of the substrate are performed after the bus bar is formed.

### SUMMARY

The present invention has been made in an effort to provide a solar cell and a manufacturing method thereof that can increase efficiency of the solar cell.

An exemplary embodiment of the present invention provides a solar cell, including: a plurality of cells of the solar cell formed on a substrate and each having a rear electrode pattern, a light absorbing layer, a buffer layer, and a front electrode; a through-hole penetrating the substrate; and a bus bar electrically connected with the rear electrode pattern through the through-hole.

Another exemplary embodiment of the present invention provides a manufacturing method of a solar cell, including: forming a through-hole penetrating a substrate; forming a bus bar in an area corresponding to the through-hole on a rear surface of the substrate; and forming a plurality of cells of the solar cell each having a rear electrode pattern, a light absorbing layer, a buffer layer, and a front electrode, on a front surface of the substrate, wherein the bus bar is electrically connected with the rear electrode pattern through the through-hole.

In a solar cell and a manufacturing method thereof according to exemplary embodiments of the present invention, a connection electrode which has a smaller width than a bus bar is connected with a rear electrode pattern through a through-hole, and as a result, a cell forming area of the solar cell is widened, thereby increasing efficiency of the solar cell.

### BRIEF DESCRIPTION OF THE DRAWINGS

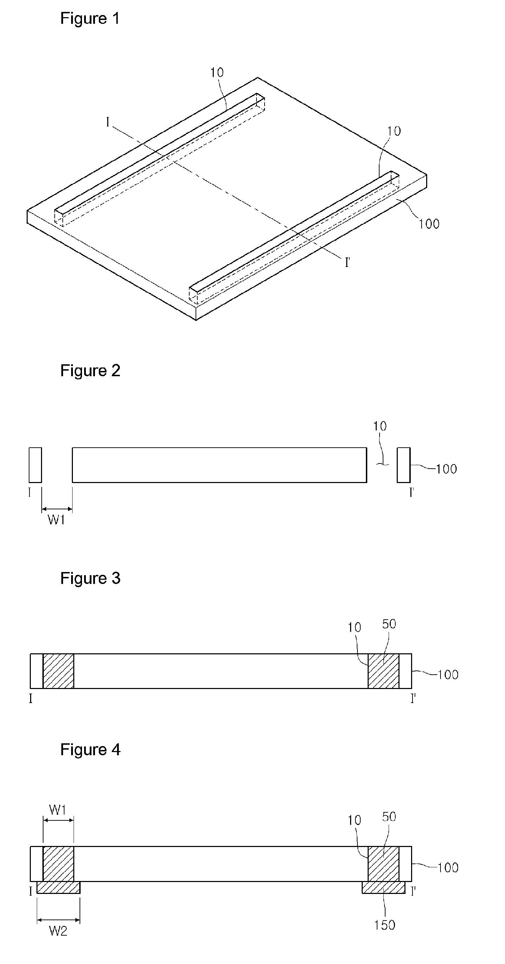

FIGS. 1 to 11 are plan views and cross-sectional views showing a manufacturing method of a solar cell according to an exemplary embodiment.

### DETAILED DESCRIPTION

In describing embodiments, it will be understood that when, a substrate, a layer, a film, or an electrode is referred to as being "on" or "under" a layer, a film, or an electrode, "on" and "under" include "directly" or "indirectly". Further, "on" or "under" of each component will be described based on the drawings. The size of each component may be enlarged for description and does not represent an actually adopted size.

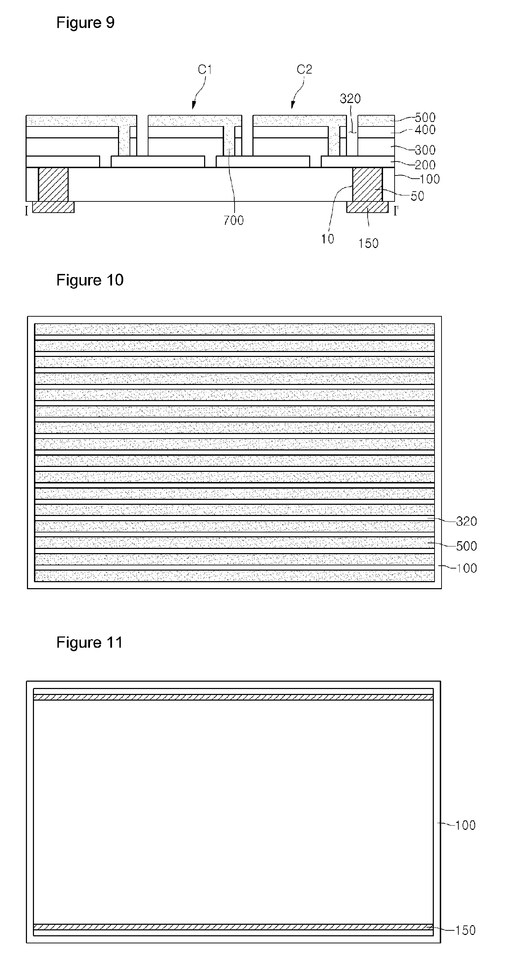

FIG. 9 is a cross-sectional view of a solar cell according to an exemplary embodiment.

The solar cell according to the exemplary embodiment includes a rear electrode pattern 200 formed on a substrate 100, a light absorbing layer 300, a buffer layer 400, a front electrode 500, a through-hole 10, a connection electrode 50, and a bus bar 150.

The through-hole 10 is formed to penetrate the substrate 100 and the connection electrode 50 is formed by filling a conductive material in the through-hole 10.

The bus bar 150 is electrically connected to a rear surface of the substrate 100 in contact with the connection electrode 50.

The connection electrode 50 contacts the rear electrode pattern 200 to be electrically connected to electrically connect the bus bar 150 with the rear electrode pattern 200.

In this case, the bus bar 150 is electrically connected to the rear electrode pattern 200 formed at the outermost side of the substrate 100.

Herein, the solar cell will be described in detail according to a manufacturing process of the solar cell.

FIGS. 1 to 11 are plan views and cross-sectional views of a manufacturing method of a solar cell according to an exemplary embodiment.

First, as shown in FIGS. 1 and 2, the through-hole 10 penetrating the substrate is formed.

Glass is used as the substrate 100 and a ceramic substrate such as alumina, stainless steel, a titanium substrate, or a polymer substrate may be used.

Sodaline glass may be used as the glass substrate and polyimide may be used as the polymer substrate.

Further, the substrate 100 may be rigid or flexible.

The shape of the through-hole 10 may be changed depending on the shapes of a bus bar and a rear electrode pattern to be formed thereafter, but in the exemplary embodiment, the through-hole 10 which elongates in one direction.

FIG. 2 is a cross-sectional view taken along line I-I' of FIG. 1.

Two through-holes 10 are formed at both edges of the substrate 100.

In this case, one through-hole is connected a bus bar to be connected with a positive (+) electrode and the other through-hole is connected with a bus bar to be connected with a negative (-) electrode. As described above, two through-holes are formed.

However, the number of the through-holes 10 is not limited thereto, but the number of the through-holes 10 may be changed depending on the structure of the cells of the solar cell.

The width W1 of the through-hole 10 may be in the range of 0.5 to 3 mm and may be preferably in the range of 1 to 2 mm.

Subsequently, as shown in FIG. 3, the connection electrode 50 filled in the through-hole 10 is formed.

The connection electrode 50 may be formed by inserting Ag or Al paste to be filled in the through-hole 10 and further, may be formed by inserting molybdenum (Mo) which is a rear electrode material.

However, the material forming the connection electrode 50 is not limited thereto, but the connection electrode 50 may be made of a conductive material.

In addition, as shown in FIG. 4, the bus bar 150 is formed on the rear surface of the substrate 100.

The bus bar 150 may be exposed on the rear surface of the substrate 100. The bus bar 150 contacts the connection electrode 50 to be electrically connected with the connection electrode 50.

The bus bar 150 may be made of the conductive material including Al and Cu.

The bus bar 150 may have a width W2 in the range of 1 to 5 mm and may preferably have a width in the range of 3 to 4 mm.

In addition, the bus bar 150 may be wider than the width W1 of the connection electrode 50.

In this case, forming sequences of the connection electrode 50 and the bus bar 150 may be exchanged to each other. That is, the connection electrode 50 is formed and thereafter, the bus bar 150 is formed in the exemplary embodiment, but the bus bar 150 is first formed and thereafter, the connection electrode 50 may be formed.

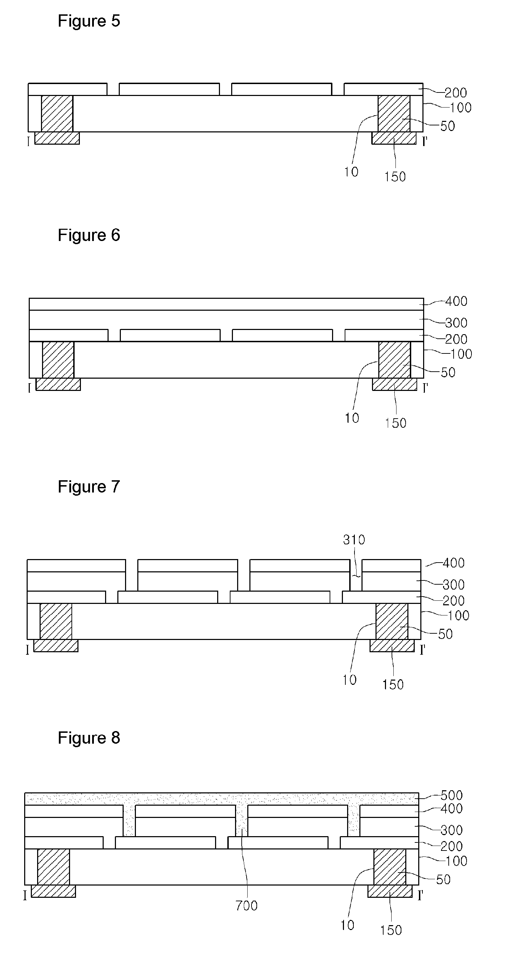

Subsequently, as shown in FIG. 5, the rear electrode pattern 200 is formed on a front surface of the substrate 100.

The rear electrode pattern 200 may be made of a conductor such as metal.

For example, the rear electrode pattern 200 may be formed through a sputtering process by using a molybdenum target.

This is to achieve high electrical conductivity of molybdenum (Mo), ohmic junction with the light absorbing layer, and high-temperature stability under a Se atmosphere.

The rear electrode pattern 200 may be formed to cover the through-hole 10. That is, the rear electrode pattern 200 contacts the connection electrode 50 to be electrically connected with the connection electrode 50.

That is, the rear electrode pattern 200 and the bus bar 150 may be electrically connected with each other by the connection electrode 50.

In this case, the through-hole 10 is formed at the edge of the substrate 100 to electrically connect the rear electrode pattern 200 formed at the outermost side of the substrate 100 and the bus bar 150 to each other.

Further, although not shown in the figure, the rear electrode pattern 200 may be formed by at least one layer.

When the rear electrode pattern 200 is formed by a plurality of layers, the layers constituting the rear electrode pattern 200 may be made of different materials.

A part of the substrate 100 may be exposed between the rear electrode patterns 200.

Further, the rear electrode patterns 200 may be placed in a stripe type or matrix type and correspond to the cells, respectively.

However, the type of the rear electrode pattern 200 is not limited thereto, but the rear electrode pattern may have various types.

The connection electrode 50 and the bus bar 150 are formed and thereafter, the rear electrode pattern 200 is formed to electrically connect the rear electrode pattern 200 and the bus bar 150 to each other in the exemplary embodiment, but is not limited thereto and only the bus bar 150 is formed on the rear surface of the substrate 150 and thereafter, the rear electrode pattern 200 may be formed.

That is, after the bus bar 150 is formed without forming the connection electrode 50, the material of the rear electrode pattern 200 is inserted into the through-hole 10 to be electrically connected with the bus bar 150 when the rear electrode pattern 200 is formed.

In addition, as shown in FIG. 6, the light absorbing layer 300 and the buffer layer 400 are formed on the rear electrode pattern 200.

The light absorbing layer 300 includes a Ib-IIIB-VIb based compound.

More specifically, the light absorbing layer 300 includes a copper-indium-gallium-selenide based (Cu(In, Ga)Se₂, CIGS based) compound.

Contrary to this, the light absorbing layer 300 includes a copper-indium-selenide based (CuInSe₂, CIS based) CIGS based) compound or a copper-gallium-selenide based (CuGaSe₂, CIS based) compound.

For example, a CIG based metallic precursor layer is formed on the rear electrode pattern 200 by using a copper target, an indium target, and a gallium target, in order to form the light absorbing layer 300.

Thereafter, the metallic precursor layer reacts with selenium (Se) to form the CIGS based light absorbing layer 300 by a selenization process.

Further, during the process of forming the metallic precursor layer and the selenization process, an alkali component included in the substrate 100 is diffused to the metallic precursor layer and the light absorbing layer 300 through the rear electrode pattern 200.

The alkali component can increase a grain size of the light absorbing layer 300 and improve crystallinity. Further, the light absorbing layer 300 may be formed by co-evaporating copper (Cu), indium (In), gallium (Ga), and selenide (Se).

The light absorbing layer 300 is formed on the rear electrode pattern 200 and may be formed on the substrate 100 of which a part is exposed between the rear electrode patterns 200.

The light absorbing layer 300 receives external light to convert the received external light into electric energy. The light absorbing layer 300 generates photovoltaic force by a photoelectric effect.

The buffer layer 400 is formed on the light absorbing layer 300 and by at least one layer and may be formed by plating any one of cadmium sulfide (CdS), ITO, ZnO, and i-ZnO or laminating cadmium sulfide (CdS), ITO, ZnO, and i-ZnO on the substrate 100 with the light absorbing layer 300.

In this case, the buffer layer 400 is an n-type semiconductor layer and the light absorbing layer 300 is a p-type semiconductor layer. Therefore, the light absorbing layer 300 and the buffer layer 400 form a pn junction.

The buffer layer 400 is placed between the light absorbing layer 300 and the front electrode to be formed thereon.

That is, since the difference in lattice constant and energy bandgap between the light absorbing layer 300 and the front electrode is large, the buffer layer 400 having a bandgap which is an intermediate between the bandgaps of both the materials is inserted between the light absorbing layer 300 and the front electrode to achieve an excellent junction.

One buffer layer is formed on the light absorbing layer 300 in the exemplary embodiment, but the buffer layer is not limited thereto and the buffer layer may be formed by a plurality of layers.

Subsequently, as shown in FIG. 7, a contact pattern 310 penetrating the light absorbing layer 300 and the buffer layer 400 is formed.

The contact pattern 310 may be formed by a mechanical method and a part of the rear electrode pattern 200 is exposed on the contact pattern 310. The contact pattern 310 may be formed adjacent to the rear electrode pattern 200.

In addition, as shown in FIG. 8, the front electrode 500 and a connection wire 700 are formed by laminating a transparent conductive material on the buffer layer 400.

When the transparent conductive material is laminated on the buffer layer 400, the transparent conductive material is inserted into the contact pattern 310 to form the connection wire 700. That is, the front electrode 500 and the connection wire 700 may be made of the same material.

The rear electrode pattern 200 and the front electrode 500 may be electrically connected with each other by the connection wire 700.

The front electrode 500 is made of zinc oxide doped with aluminum by performing a sputtering process on the substrate 100.

The front electrode 500 as a window layer that forms the pn junction with the light absorbing layer 300 serves as the transparent electrode on the front surface of the solar cell, and as a result, the front electrode 500 is made of zinc oxide (ZnO) having high light transmittance and high electric conductivity.

In this case, an electrode having a low resistance value may be formed by doping zinc oxide with aluminum.

A zinc oxide thin film as the front electrode 500 may be formed by a method of depositing the ZnO target through an RF sputtering method, reactive sputtering using the Zn target, and a metal-organic chemical vapor deposition method.

Further, the front electrode 500 may be formed in a dual structure in which an indium tin oxide (ITO) thin film having a high electrooptical characteristic is deposited on the zinc oxide thin film.

Subsequently, as shown in FIG. 9, a separation pattern 320 penetrating the light absorbing layer 300, the buffer layer 400, and the front electrode 500 is formed.

The separation pattern 320 may be formed by the mechanical method and a part of the top of the rear electrode pattern 200 is exposed on the separation pattern 320.

The buffer layer 400 and the front electrode 500 may be distinguished by the separation pattern 320 and cells C1 and C2 may be separated from each other by the separation pattern 320.

The front electrode 500, the buffer layer 400, and the light absorbing layer 300 may be placed in the stripe type or matrix type by the separation pattern 320.

However, the type of the separation pattern 320 is not limited thereto, but the separation pattern 320 may have various types.

The cells C1 and C2 including the rear electrode pattern 200, the light absorbing layer 300, the buffer layer 400, and the front electrode 500 are formed by the separation pattern 320.

In this case, the cells C1 and C2 may be connected to each other by the connection wire 700. That is, the connection wire 700 electrically connects the rear electrode pattern 200 of the second cell C2 and the front electrode 500 of the first cell C1 adjacent to the second cell C2.

FIG. 10 is a plan view showing the front surface of the substrate 100 where the cells of the solar cell are formed by the separation pattern 320 and FIG. 11 is a plan view showing the rear surface of the substrate 100 where the bus bar 150 is formed.

Since the bus bar 150 is formed on the rear surface of the substrate 100, an electrode for transferring a signal of the bus bar to the rear surface of the substrate 100 does not need to be additionally formed by forming the bus bar on the front electrode 500.

Further, the width W1 of the connection electrode 50 directly connected with the rear electrode pattern 200 is smaller than the width W2 of the bus bar 150 to widen a cell forming area of the solar cell.

That is, the existing bus bar is formed on the front electrode 500, and as a result, the cell forming area of the solar cell is narrowed as large as the width of the bus bar, but in the exemplary embodiment, since the connection electrode 50 having the smaller width than the bus bar 150 is connected with the rear electrode pattern 200, the cell forming area of the solar cell can be widened.

Therefore, as the cell forming area of the solar cell is widened, efficiency of the solar cell can also be increased.

In the solar cell and the manufacturing method thereof according to the exemplary embodiments of the present invention, the connection electrode which has the smaller width than the bus bar is connected with the rear electrode pattern through the through-hole, and as a result, the cell forming area of the solar cell is widened, thereby increasing the efficiency of the solar cell.

While the present invention has been shown and described in connection with the exemplary embodiments, it will be apparent to those skilled in the art that modifications and variations can be made without departing from the spirit and scope of the invention as defined by the appended claims. For example, each component shown in detail in the exemplary embodiments may be modified and implemented. In addition, it should be understood that difference associated with the modification and application are included in the scope of the present invention defined in the appended claims.

## Claims

1. A solar cell, comprising:
a plurality of cells of the solar cell formed on a substrate and each having a rear electrode pattern, a light absorbing layer, a buffer layer, and a front electrode;
a through-hole penetrating the substrate; and
a bus bar electrically connected with the rear electrode pattern through the through-hole.

2. The solar cell of claim 1, wherein the bus bar is exposed on a rear surface of the substrate through the through-hole.

3. The solar cell of claim 1, further comprising a connection electrode electrically connecting the bus bar with the rear electrode pattern in contact with the rear electrode pattern and the bus bar, in the through-hole.

4. The solar cell of claim 1, wherein the bus bar is electrically connected with the rear electrode pattern formed at the outermost side of the substrate.

5. The solar cell of claim 1, wherein the through-hole is in contact with the rear electrode pattern formed at the outermost side of the substrate.

6. The solar cell of claim 1, wherein the width of the through-hole is in the range of 1 to 2 mm.

7. The solar cell of claim 3, wherein the width of the connection electrode is smaller than the width of the bus bar.

8. The solar cell of claim 3, wherein the connection electrode is made of a conductive material.

9. The solar cell of claim 3, wherein the connection electrode is made of the same material as the rear electrode pattern.

10. A manufacturing method of a solar cell, comprising:
forming a through-hole penetrating a substrate;
forming a bus bar in an area corresponding to the through-hole on a rear surface of the substrate; and
forming a plurality of cells of the solar cell each having a rear electrode pattern, a light absorbing layer, a buffer layer, and a front electrode, on a front surface of the substrate,
wherein the bus bar is electrically connected with the rear electrode pattern through the through-hole.

11. The manufacturing method of a solar cell of claim 10, further comprising forming a connection electrode filled in the through-hole, after the bus bar is formed.

12. The manufacturing method of a solar cell of claim 11, wherein the connection electrode contacts the rear electrode pattern and the bus bar to electrically connect the rear electrode pattern and the bus bar.

13. The manufacturing method of a solar cell of claim 10, wherein the forming of the plurality of cells of the solar cell including the rear electrode pattern, the light absorbing layer, the buffer layer, and the front electrode, on the front surface of the substrate includes:
forming a plurality of rear electrode patterns which are placed on the substrate to be separated from each other;
forming the light absorbing layer on the substrate where the rear electrode pattern is placed;
forming a contact pattern penetrating the light absorbing layer;
forming the front electrode on the light absorbing layer to be inserted into the contact pattern; and
forming a separation pattern on the front electrode and the light absorbing layer to be divided into unit cells.

14. The manufacturing method of a solar cell of claim 13, wherein the bus bar is electrically connected with the rear electrode pattern formed at the outermost side of the substrate.

15. The manufacturing method of a solar cell of claim 10, wherein a material of the rear electrode pattern is inserted into the through-hole to be electrically connected with the bus bar.
